# EUROPEAN PATENT APPLICATION

(11) **EP 4 550 951 A1**
(43) Date of publication of application: **07.05.2025**
(21) Application number: 23207908.7
(22) Date of filing: 06.11.2023
(51) Int. Cl.: H05K 3/40, H05K 1/14, H05K 3/00, H05K 3/34, H05K 3/42

(54) **CASTELLATED PRINTED CIRCUIT BOARD**

(71) Applicant: Lumileds LLC, San Jose, CA 95131 (US)
(72) Inventor: Khaw, Lee Peng, 11700 Gelugor (MY); Ngoh, Ying Shin, 11600 Jelutong (MY); Yeang, Jia-Chenn, 11950 Pulau Pinang (MY)
(74) Representative: dompatent von Kreisler Selting Werner - Partnerschaft von Patent- und Rechtsanwälten mbB

(57) **Abstract**

Castellated printed circuit board, PCB, comprising a PCB substrate comprising a first side and an opposite second side, one or more castellated contact comprising a conductor extending from the first side of the PCB substrate to the second side, wherein the one or more castellated contact is arranged at a corner and/or an edge of the PCB substrate, at least one cut-in feature arranged to at least partially overlap with the one or more castellated contact.

## Description

The present invention relates to a castellated printed circuit board (PCB), a panel board comprising a plurality of such castellated PCB and a method for fabricating a castellated PCB. Further the present invention relates to an LED device comprising such a castellated PCB.

The increasing demand for higher performance LED devices has spurred the need for more reliable and efficient interconnectors. One solution satisfying this demand are castellated PCBs. Castellated PCBs comprise castellated contacts. These castellated contacts are formed by drilling a hole at the quadrat edges of four PCBs at the same time in a panel board. Thus, at each corner of the four PCB boards a quarter-through-hole is formed. The side walls of these quarter-through-holes at each PCB is subsequently plated by a conductive material. Subsequently the panel board is separated into the individual PCBs by sawing, wherein the sawing trails directly across the quarter-through-holes at the corners of the PCBs. This stimulates mechanical forces and stresses on the leading edges which may compromise the adhesion of the plating deposition onto the side walls of the PCB substrate and likely courses peel-off at the edges. Peel-off of castellated contacts can significantly impact the formation of good solder joints leading to microcracks and voids that disrupt the flow of electrical current and result in device malfunction. The root cause of this issue can be attributed to the PCB sawing process which weakens the plating strengths on the PCB substrate due to induced mechanical forces and stress.

It is an object of the present invention to provide a castellated PCB and a method for fabricating a castellated PCB with improved castellated contacts whereby peel-off of the conductor layer is prevented.

The problem is solved by a castellated printed circuit board (PCB) according to claim 1, a panel board according to claim 6, a method for fabricating a castellated PCB and an LED device comprising such a castellated PCB.

In an aspect of the present invention a castellated PCB is provided comprising a PCB substrate having a first side or upper side and an opposite second side or lower side. Further, the castellated PCB comprises one or more castellated contacts comprising a conductor or conductor layer extending from the first side of the PCB substrate to the second side, wherein the one or more castellated contact is arranged at a corner of the PCB substrate. Alternatively or additionally the castellated contact is arranged at an edge of the PCB substrate. In particular the castellated contact as known from the prior art is formed by a castellated recess and in particular a circular or arc shaped recess either in the edge or the corner of the PCB substrate. Further, according to the present invention at least one cut-in feature is arranged to at least partially overlap with the one or more castellated contact. By the cut-in feature overlapping at least partially with the castellated contact and in particular with the castellated recess, the area of the side wall covered by the conductor layer is reduced. Thus, the conductor layer is not present at the position where the sawing blade trails cross the castellated recesses of the castellated contact. Hence, mechanical force and stress induced by the sawing blade is not interacting with the conductor layer of the castellated contact. The sawing process cannot affect any more the conductor layer of the castellated contact preventing delamination. Hence electrical contact and quality of solder joint can be improved, and rejects caused by conductor layer delamination or resulting solder joint cracks due to damages of the conductor layer by the sawing process of the castellated contacts can be reduced.

Preferably, the castellated contact and in particular the conductor layer of the castellated contact comprises a starting point and an end point along the edge of the PCB substrate, wherein by the cut-in feature the starting point and/or the end point of the castellated contact/conductor layer is distant from the edge of the PCB substrate. Therein, the edge of the PCB substrate is defined by the sawing trail. Since the starting point and/or the end point of the castellated contact and in particular the conductor layer is distant from the edge of the PCB substrate and consequently distant from the sawing trails, mechanical force induced by the sawing blade cannot interact with the conductor layer of the castellated contact. Quality of the castellated contact and in particular the conductor layer is improved and delamination due to the sawing process can be prevented.

Preferably, the castellated contact is part-circular shaped or shaped as a circular arc. In particular, if the castellated contact is arranged at a corner of the castellated PCB, the castellated contact may be quarter-circle shaped. Similar, if the castellated contact is arranged at an edge of the castellated PCB, the castellated contact may be half-circle shaped. However, the castellated recesses at the corner of the PCB substate or the edges of the PCB substrate may shaped by a larger or smaller fraction of a circle. In particular by using a part-circular shaped castellated contact, the castellated contact can be formed by drilling.

Preferably, the cut-in feature is part-circular shaped or shaped as a circular arc. Therein, a circle forming the part-circular shaped cut-in feature may overlap with the castellated recess of the castellated contact. In particular, if the castellated recess is also formed by a part-circular segment, the circle forming the part-circular shaped cut-in feature overlaps with the circle forming the castellated contact/ the castellated recess. Hence the castellated contact as well as the cut-in feature can be both fabricated by drilling.

Preferably, the part-circular shaped castellated contact has a radius larger than the circular segment shaped cut-in feature. Thus, by the cut-in feature only a fraction of the castellated contact is affected in order to prevent interaction of the conductor layer with the sawing blade, i. e. that the starting point and/or the end point of the conductor layer along the edge of the PCB substrate is distant from the sawing trails when separating the castellated PCB.

Preferably, the cut-ins are formed on both sides of each of the castellated contact. Although one cut-in feature at the trailing edge of the sawing trails might be sufficient to substantially reduce delamination of the conductor layer, it may be beneficial that cut-in features are formed on both sides along the sawing trail or the sidewall of the castellated PCB of each of the castellated contact to prevent any contact between the sawing blade and the conductor layer.

Preferably, the castellated PCB comprises more than one castellated contact. Preferably the castellated contacts are arranged at one or more, and preferably at all four corners of the PCB substrate. Additional or alternatively the castellated PCB may comprise one or more castellated contacts on one or more of the edges of the PCB substrate. Each castellated contact may have adjacent cut-in features as described before. In particular each castellated contact may overlap with one and more preferably with two cut-in features. Therein, it is of course possible that one cut-in feature overlaps with two adjacent castellated contacts at the same time in order to reduce the number of cut-in features which are necessary.

Preferably the conductor layer is made from copper, silver, gold, tin or any other conductive material.

Preferably, the diameter of the circle forming the part-circular shaped castellated contact or castellated recess may have a diameter of between 0.5mm to 10mm. Preferably, the circle forming the part-circular shaped cut-in feature may have a diameter which is a fraction of between 0.1 and 1 of the diameter of the circle forming the part-circular shaped castellated contact. However, the present invention is not limited to the specific dimensions and other dimensions are also possible.

Preferably, the sidewall of the cut-in features are not covered by the conductor layer. In particular, the conductor layer starts/ends at the contact or crossing point of the cut-in feature and the castellated recess.

Preferably, the cut-in feature overlaps with an edge of the PCB substrate forming the castellated PCB. Thus, by the cut-in feature part of the edge of the PCB substrate is shaped to prevent contact between the sawing blade and the conductor layer.

In an aspect of the present invention a panel board is provided comprising a plurality of castellated PCB. Therein, the castellated PCBs of the panel board are connected to each other and separated into individual castellated PCBs preferably by sawing. Therein the castellated PCBs in the panel board are arranged in an array.

Preferably, the one or more castellated contacts, i.e. their castellated recess, and the cut-in features of neighbouring castellated PCBs are arranged at opposite position, i. e. facing each other, such that the castellated contact and the cut-in features of at least two neighbouring castellated PCBs can be fabricated in a common step. In particular this common step can be a drilling step, wherein the drilled hole forms a castellated contact and/or a respective cut-in feature in the at least two neighbouring castellated PCBs. Therein, in particular two neighbouring castellated PCBs are affected, if the castellated contact and/or the cut-in features are formed in the edges of the neighbouring castellated PCBs. Four neighbouring castellated PCBs are affected if castellated contacts at corners of four neighbouring castellated PCBs are formed.

Preferably, the centre of the circle forming the castellated contacts, i.e. its castellated recess, is centred between neighbouring castellated PCBs. Hence, the centre of the circle forming the castellated contacts is centred to the sawing trail separating the individual castellated PCBs of the panel board. In particular the circle forming the castellated contact is centred also with a perpendicular crossing sawing trails if respective castellated contacts are formed at the corners of the castellated PCBs. Similar, the circle forming cut-in features at two neighbouring castellated PCBs is centred between these castellated PCBs, i. e. centred with the sawing trail separating the neighbouring castellated PCBs into individual castellated PCBs.

Preferably, the castellated PCB is fabricated by the method described below.

In an aspect of the present invention a method for fabricating castellated PCB is provided. The method includes:
Providing a PCB substrate,
Inserting one or more incisions into the PCB substrate to form one or more castellated contacts,
Inserting one or more cut-in features into the PCB substrate overlapping with respective incisions,
Plating sidewalls of the one or more incisions with a conductive material to form the castellated contacts, and
Sawing the PCB substrate into the castellated PCBs, wherein by the sawing the incisions are separated into castellated contacts of each of the castellated PCBs, wherein sawing is performed through the cut-in features.

Therein, by the incisions, when separated in the sawing step, these incisions form castellated recesses at each of the respective castellated PCBs. Therein, one incision may overlap with and form castellated recesses at one castellated PCB, two castellated PCB (if castellated contacts are formed at the edge of the respective castellated PCB), or up to four castellated PCBs (if castellated contacts are formed at the corners of the respective castellated PCB).

Preferably, the incisions are circular holes and/or the cut-in features are circular holes overlapping with one or two respective incisions.

Preferably, the diameter of the circular holes of the incision is larger than the diameter of the circular holes of the cut-in features overlapping with the respective incision.

Preferably, the incisions and/or the cut-in features are drilled or laser drilled.

Preferably, the centre point of the hole forming the castellated contact and/or the centre point of the circular hole forming the cut-in features are centred on at least one sawing trail along sawing is performed. Preferably, if the castellated contact is formed at a corner of the castellated PCB, the centre point of the circular hole forming the castellated contact is centred on two sawing trails crossing each other perpendicularly.

Preferably, for each incision one, two or four cut-in features are inserted. One cut-in feature might be sufficient if the cut-in feature is formed on the trailing edge along the sawing trail of the incision, first coming into contact with the sawing blade. However, it is beneficial to provide two cut-in features for each incision in order to completely separate the conductor layer from the sawing blade during the sawing process. In particular if the castellated contact is formed at a corner of the castellated PCB, two cut-in features may be placed overlapping with the castellated contact along each of the two crossing sawing trails resulting in up to eight cut-in features at the four neighbouring castellated PCBs.

Preferably, one incision is forming a castellated contact at two or four neighbouring castellated PCBs. If the castellated contacts are formed at the edge of the castellated PCB, by one incision two castellated contacts are formed at opposite position, i. e. facing positions at the neighbouring castellated PCB. If the castellated contact is formed in corners of the castellated PCB one incision may form castellated contacts in four neighbouring castellated PCBs. Similar one inserted cut-in feature is forming cut-in features at two neighbouring castellated PCBs.

Preferably, the method further includes steps to fabricate a castellated PCB as described before. In particular, the method is further developed along the features of the castellated PCB described before.

In an aspect of the present invention an LED device is provided comprising a castellated PCB as described before. Alternatively the LED element comprising a castellated PCB fabricated by the method described before. Further, the LED element may comprise at least one LED electrically connected to one or more of the castellated contacts of the castellated PCB.

In the following the present invention is described in more detail with reference to the accompanying figures.

The figures show:
- Figures 1A, 1B: a castellated PCB according to the present invention,
- Figures 2A, 2B: a schematic diagram for fabrication of a castellated PCB according to Figures 1A and 1B,
- Figures 3A, 3B: another embodiment of the castellated PCB according to the present invention,
- Figure 4: a schematic diagram of the fabrication of the castellated PCB according to Figures 3A and 3B, and

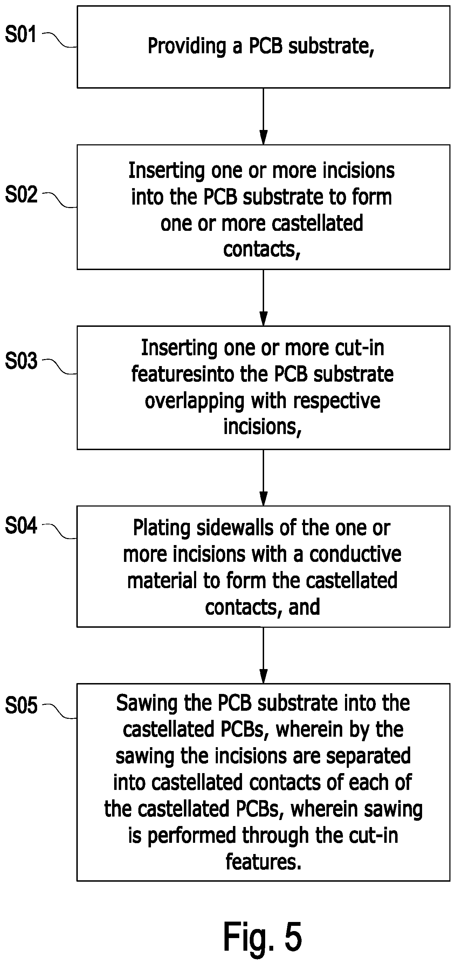

- Figure 5: a flow diagram of the method for fabricating a castellated PCB according to the present invention.

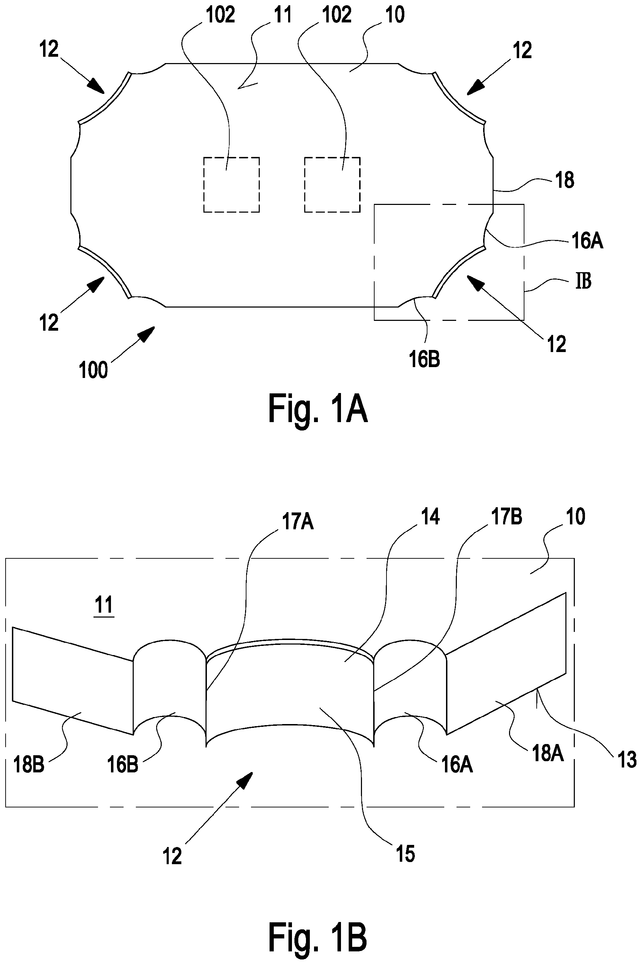

Referring to Figure 1 showing a castellated PCB 100 having a PCB substrate 10 having an upper surface 11 and a lower surface 13 connected by a side wall 18 forming the edges 18A, 18B of the PCB substrate 10. As shown in the example of Figures 1A and 1B, castellated contacts 12 are formed at the corners of the PCB substrate 10.

By the castellated PCB an LED device may be created as indicated in Figure 1A, showing LEDs 102 at the upper surface 11 of the castellated PCB, wherein the LEDs 102 may be connected and supplied by the castellated contacts 12.

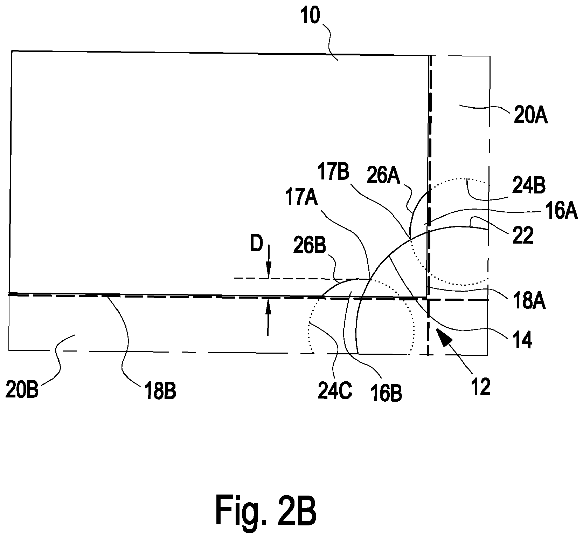

The castellated contacts 12 comprise a castellated recess 14 formed as part-circular shaped or arc shaped recess. However, the present invention is not limited to a specific shape of the castellated contacts. In particular the castellated recess 14 is formed as quarter-circular-segment. The side wall of the castellated recess 14 is covered by a conductor layer 15 providing an electrical connection extending from the lower side 13 to the upper side 11 of the PCB substrate 10. The castellated recess 14 as well as the conductor layer 15 have a starting point 17A and an end point 17B along the edge 18 of the PCB substrate 10. Adjacent to the castellated recess 14 two cut-in features 16A, 16B are arranged on both sides along the edge 18, overlapping at least partially with the castellated recess 14. The cut-in features 16A, 16B may be formed as part-circular shaped recesses or arc shaped recesses. By the cut-in features 16A, 16B the starting point 17A and the end point 17B are drawn inside of the PCB substrate 10 by an amount D as indicated in Figure 2B and away from the respective edges 18A, 18B of the PCB substrate 10. Thus the starting point 17A and end point 17B of the castellated recess 14 and consequently also the conductor layer 15 do not come into contact with the sawing blade during the sawing step of the castellated PCB 100 along the edges 18A, 18B.

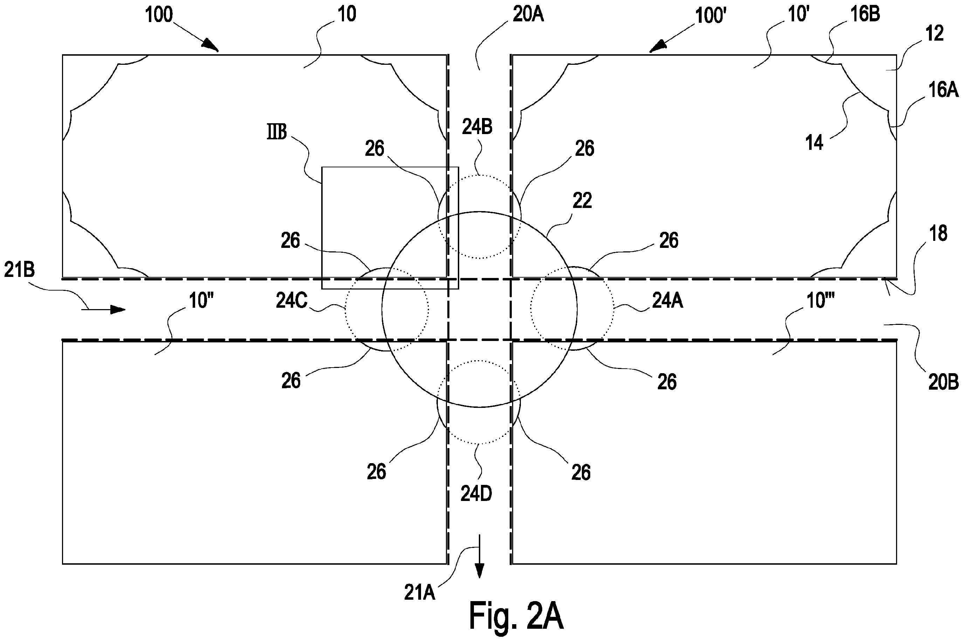

This is further explained with reference to Figures 2A and 2B showing a schematic representation of the fabrication process. In Figure 2A four neighbouring PCB substrates 10, 10', 10" and 10‴ are shown which are commonly arranged in a panel board. In a first step an incision 22 is inserted into the panel board. The incision 22 is circular in the example of Fig. 2A. By the incision 22 castellated recesses 14 are formed in the individual circuit boards 10, ... 10"', when separated by sawing along sawing trails 20A, 20B. Therein, the incision 22 is centred with a first sawing trail 20A and a second sawing trail 20B along which the individual castellated PCBs 100, 100', 100", 100‴ are separated from each other. Before separating and after inserting the incisions 22, in a subsequent step four holes 24A, 24B, 24C, 24D are inserted overlapping at least partially with the incision 22. By the holes 24A, ..., 24D cut-in features 16 are inserted into the individual PCB substrate 10, ..., 10"'. The edges 18 of the PCB substrates 10, ..., 10‴ are drawn inside by forming a circular segment 26. In Figure 2B a first circular segment 26A as cut-in feature is formed by the hole 24B, wherein a second circular segment 26B as cut-in feature is formed by the hole 24C. Thus, as shown in Figure 2B, the starting point 17A and the starting point 17B (denoting also the crossing point of the incision 22 and the respective holes 24A,..., 24D forming the cut-in features 16) are distant by a distance D from the edges 18A, 18B along which the sawing blade moves in the process of separation the PCB substrates 10, ..., 10‴ into the individual castellated PCBs 100,...,100‴. Direction of sawing is indicated by arrow 21A and 21B along the two exemplified sawing trails. Hence, by the additional holes 24A,..., 24D cut-in features 16 are formed preventing contact between the conductor layer 15 and the sawing blade.

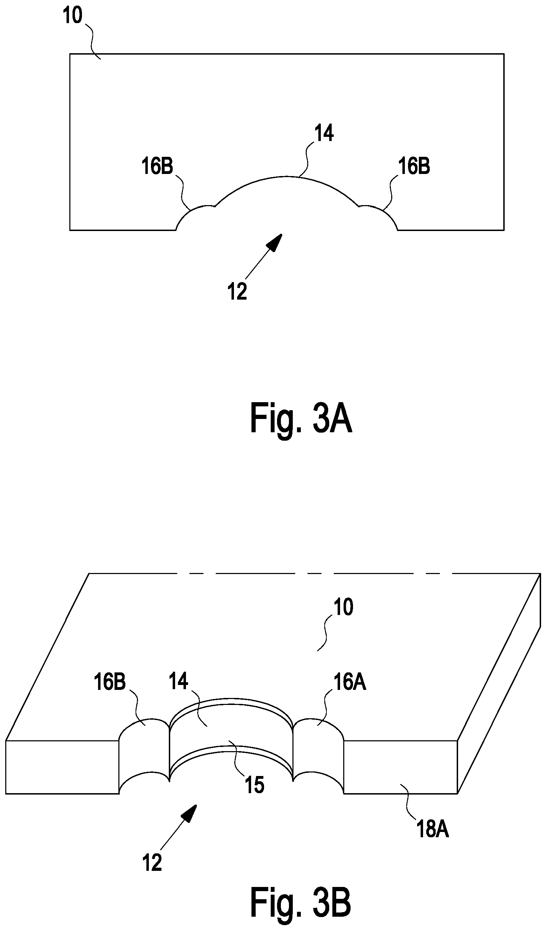

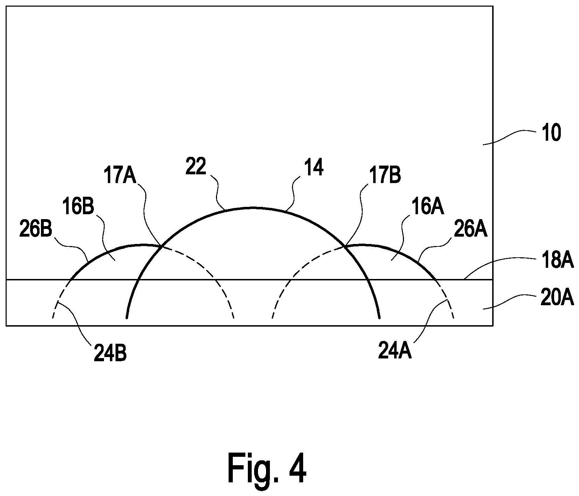

Referring to Figures 3A, 3B showing a similar configuration, wherein same or similar features are denoted by the same reference sign. The castellated contact 12 is arranged at edge 18 of the PCB substrate. Therein, the castellated recess 14 is placed in the example of Figures 3A, 3B at edge 18A of the PCT substrate 10, wherein cut-in features 16A, 16B are arranged prior and after the castellated recess 14 along the edge 18A. Therein, the starting point and end point of the conductor layer 15 is distant from the edge 18A, wherein sawing is performed along the edge 18A. Hence, the conductor layer 15 does not come into contact with sawing blade and mechanical forces and stress cannot be induced into the conductor layer. This situation is shown in more detail in Figure 4, wherein an incision 22 is inserted into the PCB substrate, wherein by the incision 22 a castellated recess is generated when separating the individual castellated PCBs and may also simultaneously create a castellated recess in an adjacent PCB substrate (not shown). Subsequently holes 24A, 24B are inserted partially overlapping with the incision 22, thereby creating cut-in features 16A, 16B respectively. The edge 18A of the PCB substrate 10 is shaped into circular segments 26A, 26B, respectively, by the holes 24A, 24B and the starting point 17A and end point 17B of the conductor layer 15 are distant and separated from the edge 18A. When separating the PCB substrates into the individual castellated PCBs along the sawing trail 20A, the sawing blade cuts through the incision 22 and also the holes 26A, 26B without coming into contact with the conductor layer 15 at the side wall of the castellated recess 14.

Referring to figure 15 showing schematically a method for fabricating of a castellated PCB 100. The method includes:
In step S01, a PCB substrate is provided.
In step S02, one or more incisions are inserted into the PCB substrate to form one or more castellated contacts,
In step S03, one or more cut-in features are inserted into the PCB substrate overlapping with respective incisions.
In step S04, sidewalls of the one or more incisions are plated with a conductive material to form the castellated contacts.
In step S05, the PCB substrate is sawn into the castellated PCBs, wherein by the sawing the incisions are separated into castellated contacts of each of the castellated PCBs, wherein sawing is performed through the cut-in features.

Thus, according to the present invention, by the cut-in features, separation of the conductor layer from the sawing blades is achieved. Hence adverse affecting of the conductor layer and in particular peel-off of the conductor layer and deterioration of the solder joints is consequently prevented since no stress or mechanical forces from the sawing blade is induced into the conductor layer.

## Claims

1. Castellated printed circuit board, PCB, comprising
a PCB substrate comprising a first side and an opposite second side,
one or more castellated contacts comprising a conductor layer extending from the first side of the PCB substrate to the second side, wherein the one or more castellated contact is arranged at a corner and/or an edge of the PCB substrate,
at least one cut-in feature arranged to at least partially overlap with the one or more castellated contacts.

2. Castellated PCB according to claim 1, wherein the castellated contact comprises a starting point and an end point along the edge of the PCB substrate, wherein by the cut-in feature the starting point and/or the end point of the castellated contact is distant from the edge of the PCB substrate.

3. Castellated PCB according to claim 1 or 2, wherein the castellated contact is circular segment shaped and/or the cut-in feature is circular segment shaped, wherein a circle forming the circular segment shaped castellated contact overlaps with a circle forming the circular segment shaped cut-in feature.

4. Castellated PCB according to claim 3, wherein the circular segment shaped castellated contact has a radius larger than the circular segment shaped cut-in feature.

5. Castellated PCB according to any of claims 1 to 4, wherein cut-ins are formed on both sides of each the castellated contact.

6. Panel Board comprising a plurality of castellated printed circuit boards, PCB, according to any of claims 1 to 5 to be separated into individual castellated PCBs, wherein the castellated PCBs are arranged in an array.

7. Panel Board according to claim 6, wherein the one or more castellated contacts and the cut-in features of neighboring castellated PCBs are arranged at opposite positions such that the castellated contacts and the cut-in features of at least two neighboring castellated PCBs can be fabricated in a common step.

8. Method for fabricating a castellated printed circuit board, PCB, including
Providing a PCB substrate,
Inserting one or more incisions into the PCB substrate to form one or more castellated contacts,
Inserting one or more cut-in features into the PCB substrate overlapping with respective incisions,
Plating sidewalls of the one or more incisions with a conductive material to form the castellated contacts, and
Sawing the PCB substrate into the castellated PCBs, wherein by the sawing the incisions are separated into castellated contacts of each of the castellated PCBs, wherein sawing is performed through the cut-in features.

9. Method according to claim 8, wherein incisions are circular holes and/or cut-in features are circular holes overlapping with respective incisions.

10. Method according to claim 9, wherein the diameter of the circular hole of the incision is larger than the diameter of the circular hole of the cut-in feature.

11. Method according to claims 9 or 10, wherein the incisions and/or the cut-in features are drilled or laser drilled.

12. Method according to any of claims 9 to 11, wherein the center point of the incision and/or the center point of the cut-in feature are centered on at least one sawing trail along sawing is performed.

13. Method according to any of claims 8 to 12, wherein for each incision one, two or four cut-in features are inserted.

14. Method according to any of claims 8 to 13, wherein one incision is forming castellated contacts at two or four neighboring castellated PCBs and/or wherein one inserted cut-in feature is forming cut-in features at two neighboring castellated PCBs.

15. LED device comprising a castellated PCB according to any of claims 1 to 5 or fabricated by the method according any of claims 8 to 14, and at least one LED electrically connected to one or more of the castellated contacts.
